Europäisches Patentamt

European Patent Office

Office européen des brevets

(19)

(11) Veröffentlichungsnummer: **0 233 967**
**B1**

(12) **EUROPÄISCHE PATENTSCHRIFT**

(45) Veröffentlichungstag der Patentschrift:
26.04.89

(21) Anmeldenummer: 86102177.2

(22) Anmeldetag: 20.02.86

(51) Int. Cl.⁴: **H03J 7/18**

(54) **Verfahren zum Übertragen einer digitalen Information sowie zum Abstimmen eines mobilen Rundfunkempfängers mit Hilfe dieser übertragenen digitalen Information.**

(43) Veröffentlichungstag der Anmeldung:
02.09.87 Patentblatt 87/36

(45) Bekanntmachung des Hinweises auf die Patenterteilung:
26.04.89 Patentblatt 89/17

(84) Benannte Vertragsstaaten:
AT BE CH DE FR GB IT LI LU NL SE

(56) Entgegenhaltungen:
EP-A- 0 092 055
EP-A- 0 150 297
DE-A- 3 104 845
DE-A- 3 208 360
DE-A- 3 208 760
DE-A- 3 322 987
DE-A- 3 432 848
DE-A- 3 448 043

FUNKSCHAU, Nr. 5, März 1982, Seiten 53-56, München, DE; P. BAUER: "Mehr als ein Autoradio"

(73) Patentinhaber: **IRT Inventions Research Technology Patent-Holding AG, Stadthausquai 5, CH-8001 Zürich(CH)**

(72) Erfinder: **Mieike, Jürgen, Dipi.-Ing., Floriansmühlstrasse 70, D-8000 München 45(DE)**

(74) Vertreter: **Haft, Berngruber, Czybulka, Postfach 14 02 46 Hans-Sachs-Strasse 5, D-8000 München 5(DE)**

## Beschreibung

Die Erfindung bezieht sich auf ein Verfahren gemäß dem Oberbegriff des Patentanspruchs 1.

Im Rahmen des bekannten Radio-Daten-Systems (RDS), wie es beispielsweise in dem Technischen Dokument Doc. Tech. Nr. 3244 der Europäischen Rundfunk-Union beschrieben ist, ist es u.a. möglich, als Inhalt des auf einen 57 kHz-Hilfsträger aufmodulierten Datensignals eine Liste alternativer Frequenzen (AF) zu übertragen. Diese Information ist insbesondere für den mobilen Empfang gedacht und sagt aus, auf welchen Frequenzen ein bestimmtes Programm von der gleichen Senderkette (z.B. BR 3) ausgestrahlt wird. Dadurch wird es geeignet ausgebildeten Empfängern mit Speicher ermöglicht, diese Liste abzuspeichern und so die Zeit zum Einstellen des Empfängers auf die jeweils optimale Frequenz dieser Liste (z.B. nach optimalen Empfangsbedingungen) zu reduzieren. Die Liste ist vereinbarungsgemäß auf maximal 25 Frequenzen oder Kanalnummern begrenzt. Im Falle von Sendernetzen mit mehr als 25 Sendern, wie dies beispielsweise für das Sendernetz Bayern 3 zutrifft, läßt sich keine für alle Sender des Sendernetzes gemeinsame Liste aussenden; vielmehr muß jeder Sender oder jede Gruppe räumlich benachbarter Sender eine eigene Liste aussenden, welche maximal 25 Frequenzen enthalten darf. Die Schwierigkeit dabei liegt darin, daß infolge der Vielzahl von Ballstrecken in der Sendernetzstruktur innerhalb der öffentlichrechtlichen Rundfunkanstalten der Bundesrepublik Deutschland die vom Muttersender ausgesendete Liste für den Tochtersender u.U. nicht paßt; sie muß nach dem Ballempfänger ausgefiltert und durch die für den jeweiligen Tochtersender zutreffende Liste ersetzt werden. Diese Ausfilterung und Neueinspeisung ist mit erhöhtem Aufwand verbunden. Hinzu kommt, daß durch die Filterung auch die Qualität des Programmsignals verschlechtert wird. Bei Senderketten mit weniger als 25 Sendern wäre zwar die Aufnahme aller Senderfrequenzen in einer gemeinsamen Liste möglich, doch würde dies bei sehr vielen Senderfrequenzen zu entsprechend langen Einstellzeiten der Empfänger führen.

Die Aufgabe der Erfindung besteht demgegenüber darin, ein Verfahren der eingangs erwähnten Art anzugeben, bei welchem eine Filterung und Neueinspeisung der Liste alternativer Frequenzen vermieden und in der Regel eine relativ kurze Einstellzeit der Empfänger gewährleistet werden kann.

Diese Aufgabe wird erfindungsgemäß durch die kennzeichnenden Merkmale des Patentanspruchs 1 gelöst.

Eine bevorzugte Anwendung der nach dem erfindungsgemäßen Verfahren übertragenen digitalen Information zum Abstimmen eines mobilen Rundfunkempfängers ergibt sich aus dem Patentanspruch 2.

Bei dem erfindungsgemäßen Verfahren strahlt jeder Sender nicht nur seine eigene Liste, sondern sequentiell auch die Listen aller weiteren Sender derselben Senderkette aus, wobei die Betriebsfrequenzen der einzelnen Sender jeweils am Anfang der einzelnen Listen stehen. Der Empfänger kann daher nach erfolgtem Empfang aller Listen aufgrund seiner momentanen Abstimmfrequenz die zu dem momentan eingestellten Sender gehörende Liste selektieren, indem er die Abstimmfrequenz mit der ersten Frequenz jeder Liste innerhalb der Listenfolge vergleicht. Eine Filterung und Neueinspeisung wird dadurch beim Ballempfang überflüssig. Ferner erkennt der Empfänger auch die alternativen Frequenzen, auf denen er bei Verlassen des Versorgungsbereichs des momentan eingestellten Senders das gleiche Programm weiter empfangen kann, ohne daß er die alternativen Frequenzen der übrigen Listen prüfen muß. Das Umschalten auf einen anderen Sender derselben Senderkette kann auf diese Weise in der Regel sehr rasch durchgeführt werden.

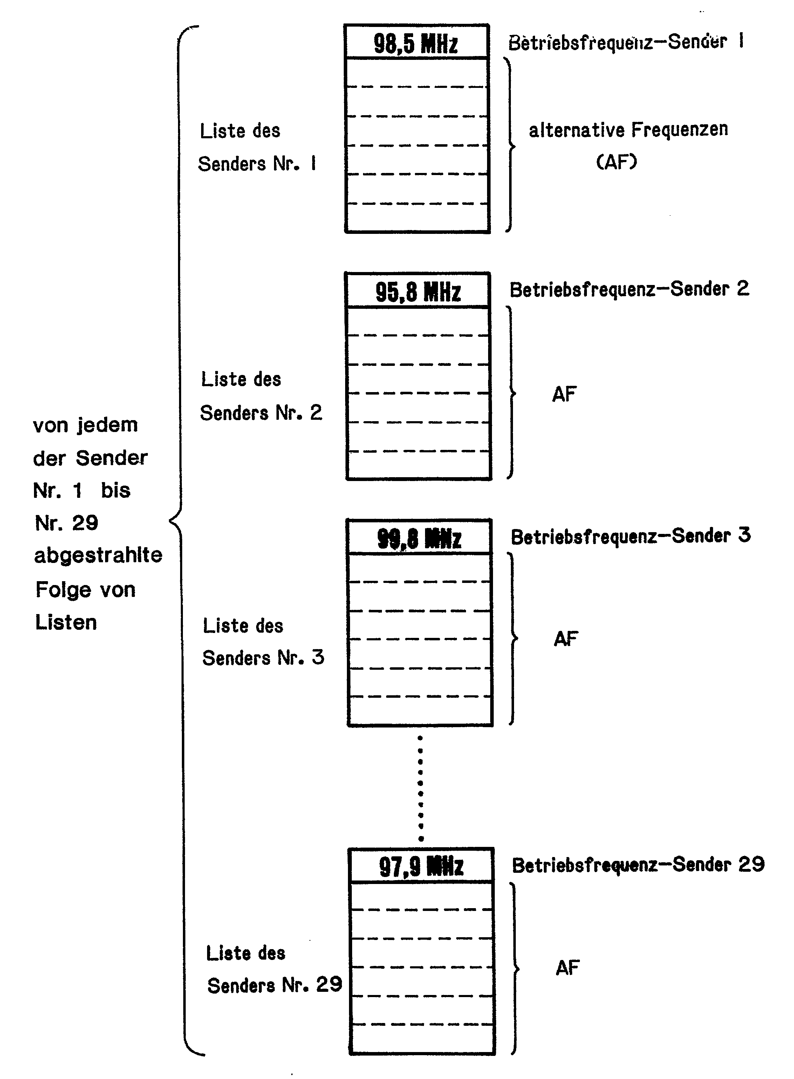

Die Erfindung wird anhand der Zeichnung näher erläutert, welche eine schematische Darstellung der von jedem Sender einer Senderkette abgestrahlten Folge von Listen alternativer Frequenzen zeigt. Im betrachteten Beispielsfall wird von einem Rundfunksignal ausgegangen, in welches ein Hilfsträger von 57 kHz eingefügt ist. Der Hilfsträger kann eine Amplitudenmodulation enthalten, welche eine Verkehrsfunkkennung zum Inhalt hat. Als Modulation bzw. als weitere Modulation ist dem Hilfsträger ein Datensignal aufgeprägt, welches in einer bestimmten, hier nicht näher interessierenden Weise codiert ist. Dieses Datensignal wird in übereinstimmender Form von sämtlichen Sendern einer Senderkette übertragen, beispielsweise von sämtlichen 29 Sendern der Senderkette "Bayern 3" im Versorgungsbereich des Bayerischen Rundfunks. Das übereinstimmend übertragene Datensignal enthält eine Folge von Listen alternativer Frequenzen für sämtliche Sender der Senderkette, im dargestellten Beispielsfall die Liste des Senders Nr. 1, die Liste des Senders Nr. 2, die Liste des Senders Nr. 3 bis zur Liste des Senders Nr. 29 für den Fall einer Senderkette mit 29 Sendern. Jede Liste ist auf den jeweiligen Sender speziell zugeschnitten und enthält entsprechend der Vereinbarung innerhalb der Europäischen Rundfunk-Union maximal 25 Frequenzen, im Regelfall jedoch erheblich weniger. Erfindungsgemäß steht am Beginn jeder Liste die Betriebsfrequenz des zugehörigen Senders, d.h., bei der Liste des Senders Nr. 1 steht am Anfang die Betriebsfrequenz des Senders Nr. 1, z.B. 98,5 MHz. Wie erwähnt, wird die dargestellte Folge von 29 Listen von jedem Sender der Senderkette als Datensignal übertragen.

Der Empfänger empfängt und decodiert das übertragene Datensignal, d.h., die Folge von Listen alternativer Frequenzen. Um die für den momentan abgestimmten Sender gültige Liste aus der empfangenen Listenfolge zu selektieren, braucht der Empfänger lediglich die erste Frequenz jeder Liste mit der momentanen Abstimmfrequenz zu vergleichen, was selbst bei 29 Listen in äußerst kurzer Zeit durchführbar ist. Diese Selektion kann entweder im On-Line-Betrieb oder im Off-Line-Betrieb erfolgen, d.h., ohne oder mit Zwischenspeicherung der empfangenen Folge von Listen. In jedem Falle wird die selektierte Liste gespeichert. Bei der Verarbeitung der empfangenen und ggf. zwischengespeicherten Folge von Listen selektiert der Empfänger diejenige Liste, deren erste Frequenz (gleich Betriebsfrequenz des zugeordneten Senders) mit der momentanen Abstimmfrequenz übereinstimmt. Stimmt die erste Frequenz mehrerer Listen mit der eingestellten Betriebsfrequenz überein, so müssen alle diese Listen selektiert werden. Ausschließlich die selektierte(n) Liste(n) wird(werden) für die anschließende Optimierung der Abstimmung verwendet. Dieser Abstimmvorgang erfolgt entweder durch einen entsprechenden Befehl des Hörers oder automatisch, wenn beispielsweise der momentan empfangene Sender nicht mehr empfangswürdig ist. Bei dem Abstimmvorgang stimmt der Empfänger selbsttätig auf die in der(den) selektierten Liste(n) aufgeführten alternativen Frequenzen ab und selektiert diejenige alternative Frequenz, welche den bestmöglichen Empfang bietet.

Mit Hilfe des erfindungsgemäß übertragenen Datensignals läßt sich auch bei Senderketten mit mehr als der festgelegten maximalen Anzahl von alternativen Frequenzen eine rasche Optimierung der Abstimmung mobiler Empfänger durchführen, ohne daß eine Ausfilterung und Neueinspeisung von Frequenzlisten am Standort von Tochtersendern erforderlich wird.

## Patentansprüche

1. Verfahren zum optimalen Abstimmen eines mobilen Rundfunkempfängers mit Hilfe einer digitalen Information, welche innerhalb eines Rundfunksignals von Rundfunksendern übertragen wird und welche als "alternative Frequenzen" bezeichnete Betriebsfrequenzen solcher Rundfunksender einer Senderkette angeben, von welchen dasselbe Programmsignal empfangbar ist, bei dem
- die empfangenen alternativen Frequenzen gespeichert werden,
- der Rundfunkempfänger auf die gespeicherten alternativen Frequenzen nacheinander zu Prüfzwecken abgestimmt wird, und
- als momentane Empfangsfrequenz diejenige alternative Frequenz ausgewählt wird, welche momentan den bestmöglichen Empfang bietet,
dadurch gekennzeichnet, daß
a) den alternativen Frequenzen jedes Rundfunksenders dessen Betriebsfrequenz vorangestellt wird, so daß sich eine eindeutige Zuordnung von Sender und dessen zugehörigen alternativen Frequenzen ergibt,
b) von jedem Rundfunksender der Senderkette als digitale Information
- dessen Betriebsfrequenz zusammen mit dessen zugehörigen alternativen Frequenzen und
- die Betriebsfrequenzen aller übrigen Rundfunksender der Senderkette zusammen mit deren zugehörigen alternativen Frequenzen
als Folge von einzelnen, auf die jeweiligen Sender der Senderkette optimierten Frequenzlisten empfangen wird, und
c) von den empfangenen alternativen Frequenzen aller Frequenzlisten nur diejenigen alternativen Frequenzen auf derjenigen Liste gespeichert und für die Abstimmung verwendet werden, deren jeweils zugehörige vorangestellte Betriebsfrequenz mit der momentan eingestellten Empfangsfrequenz des mobilen Rundfunkempfängers übereinstimmt.

## Claims

1. Method of tuning a mobile radio broadcast receiver for best possible reception, utilizing digital information which is transmitted by radio broadcast transmitters within a radio signal, this digital information indicating the operating frequencies of those radio broadcast transmitters from which the same programme signal can be received, these transmitters belonging to one transmitter chain and their operating frequencies being designated as "alternative frequencies", said method comprising
- storage of the received alternative frequencies,
- tuning of the broadcast receiver to each of the stored alternative frequencies in succession, for sampling purposes, and
- selection, as the current reception frequency, of that alternative frequency which currently offers the best possible reception,
characterized in that
a) the operating frequency of each broadcast transmitter is prefixed to its alternative frequencies, the result being that each transmitter is uniquely associated with its designated alternative frequencies,
b) the digital information being received from each broadcast transmitter within the transmitter chain comprises:
- the operating frequency of the respective transmitter together with its designated alternative frequencies, and
- the operating frequencies of all the other broadcast transmitters within the transmitter chain, together with their designated alternative frequencies,
this digital information being received in the form of a sequence of individual frequency lists, each optimized to a particular transmitter within the transmitter chain, and
c) of the received alternative frequencies, of all frequency lists, the only alternative frequencies that are stored and used for tuning are those on that list which is prefixed by the same operating frequency as the one to which the mobile radio broadcast receiver is tuned at that point in time.

## Revendications

1. Procédé pour syntoniser de manière optimale un récepteur radio mobile à l'aide d'une information numérique, qui est transmise par des émetteurs radio à l'intérieur d'un signal radio, et qui indique des fréquences de service, appelées "fréquences alternatives" de tels émetteurs radio d'un groupe d'émetteurs, à partir desquels le signal de programme correspondant peut être reçu, procédé selon lequel

– les fréquences alternatives reçues sont mémorisées,

– le récepteur radio est syntonisé successivement, à des fins de contrôle, aux fréquences alternatives mémorisées, et

– la fréquence alternative qui offre momentanément la meilleure réception possible est sélectionnée comme fréquence de réception momentanée, caractérisé en ce que

a) la fréquence de service de chaque émetteur radio est placée en tête des fréquences alternatives de cet émetteur, de sorte qu'on obtient une affectation univoque des émetteurs et de leurs fréquences alternatives associées,

b) il est reçu, comme information numérique, de chaque émetteur radio du groupe d'émetteurs:

   – sa fréquence de service conjointement avec ses fréquences alternatives associées et
   – les fréquences de service de tous les autres émetteurs radio du groupe d'émetteurs conjointement avec leurs fréquences alternatives associées sous la forme d'une succession de listes de fréquences individuelles, optimisées à l'émetteur respectif du groupe d'émetteurs, et

c) parmi les fréquences alternatives reçues de toutes les listes de fréquences, ne sont mémorisées et utilisées pour la syntonisation que celles des fréquences alternatives de la liste respective dont la fréquence de service mise en tête respectivement associée coïncide avec la fréquence de réception momentanément réglée du récepteur radio mobile.

**98,5 MHz** — Bètriebsfrequenz–Sender 1

Liste des Senders Nr. 1

alternative Frequenzen (AF)

**95,8 MHz** — Betriebsfrequenz–Sender 2

Liste des Senders Nr. 2

AF

**99,8 MHz** — Betriebsfrequenz–Sender 3

Liste des Senders Nr. 3

AF

**97,9 MHz** — Betriebsfrequenz–Sender 29

Liste des Senders Nr. 29

AF

von jedem der Sender Nr. 1 bis Nr. 29 abgestrahlte Folge von Listen